(19) Europäisches Patentamt

European Patent Office

Office européen des brevets

(11) **EP 1 193 878 B1**

(12) **FASCICULE DE BREVET EUROPEEN**

(45) Date de publication et mention
de la délivrance du brevet:
**20.12.2006 Bulletin 2006/51**

(51) Int Cl.:
**H03L 7/197** (2006.01)

(21) Numéro de dépôt: **01203620.8**

(22) Date de dépôt: **25.09.2001**

(54) **Synthétiseur de fréquence et procédé de synthèse de fréquence à faible bruit**

Frequenzsynthesizer und Verfahren zur Frequenzsynthese mit geringem Rauschen

Frequency synthesizer and low-noise frequency synthesizing process

(84) Etats contractants désignés:
DE FR GB

(30) Priorité: **29.09.2000 FR 0012459**
**26.12.2000 FR 0017042**

(43) Date de publication de la demande:
**03.04.2002 Bulletin 2002/14**

(73) Titulaire: **Koninklijke Philips Electronics N.V.**
**5621 BA Eindhoven (NL)**

(72) Inventeurs:
• **Jovenin, Fabrice,**
**Société Civile S.P.I.D.**
**75008 Paris (FR)**
• **Brunel, Dominique,**
**c/o Société Civile S.P.I.D.**
**75008 Paris (FR)**
• **Wang, Z.,**
**c/o Société Civile S.P.I.D.**
**75008 Paris (FR)**

(74) Mandataire: **van Oudheusden-Perset, Laure E. et al**
**Société Civile SPID**
**156, Boulevard Haussmann**
**75008 Paris (FR)**

(56) Documents cités:
EP-A- 0 766 403     US-A- 5 055 802
US-A- 5 867 068

• SUN L ET AL: "Reduced Complexity, High Performance Digital Delta-Sigma Modulator for Fractional-N Frequency Synthesis" ISCAS '99. PROCEEDINGS OF THE 1999 IEEE INTERNATIONAL SYMPOSIUM ON CIRCUITS AND SYSTEMS. ORLANDO, FL, MAY 30 - JUNE 2, 1999, IEEE INTERNATIONAL SYMPOSIUM ON CIRCUITS AND SYSTEMS, NEW YORK, NY: IEEE, US, vol. 2 OF 6, 30 mai 1999 (1999-05-30), pages 152-155, XP002168214 ISBN: 0-7803-5472-9
• SHPERLING I: "SIGMA DELTA MODULATOR WITH A RANDOM OUTPUT BIT STREAM OF SPECIFIED 1/0 AVERAGE RATIO" MOTOROLA TECHNICAL DEVELOPMENTS, MOTOROLA INC. SCHAUMBURG, ILLINOIS, US, vol. 18, 1 mars 1993 (1993-03-01), pages 156-160, XP000349609

**Description**

Domaine technique

La présente invention concerne un synthétiseur de fréquences et un procédé pour la synthèse de fréquences à faible bruit.

Elle concerne plus particulièrement un synthétiseur de fréquences dont la fréquence de sortie peut être ajustée par valeurs entières ou fractionnaires.

Un tel synthétiseur de fréquences est utilisable dans différents types de circuits radioélectriques et en particulier dans des étages de réception et/ou d'émission de ces circuits. A titre d'exemple, le synthétiseur de fréquences de l'invention peut être utilisé dans des équipements de téléphonie sans fil, tels que les téléphones portables.

Etat de la technique antérieure

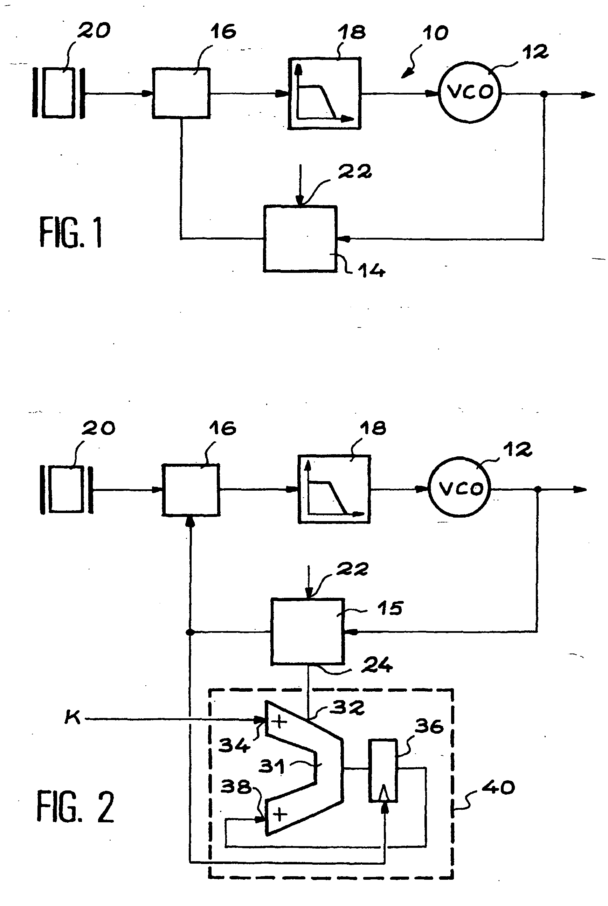

Les figures 1 et 2 annexées illustrent respectivement un synthétiseur de fréquences ajustable par valeurs entières, et un synthétiseur de fréquences ajustable par valeurs fractionnaires. On entend par synthétiseur de fréquences ajustable par valeurs fractionnaires, un synthétiseur de fréquences dont la fréquence peut être ajustée par multiples entiers ou non entiers d'une fréquence de référence. De tels dispositifs sont en soi connus et illustrés, par exemple, par les documents (1), (2) et (3) dont les références complètes sont précisées à la fin de la description.

La figure 1 indique la structure de base d'un synthétiseur de fréquences qui est construit autour d'une boucle à verrouillage de phase 10. La boucle à verrouillage de phase comporte pour l'essentiel un oscillateur commandé en tension 12, un diviseur de fréquences 14, un comparateur phase-fréquence 16 et un filtre de boucle 18.

L'oscillateur commandé en tension 12, encore désigné par « oscillateur VCO » dans la suite du texte, délivre un signal de sortie dont la fréquence peut être augmentée ou diminuée en fonction d'une tension de commande appliquée à son entrée. Cette tension de commande est fournie par le comparateur phase-fréquence 16 qui est relié à l'entrée de l'oscillateur VCO 12 par l'intermédiaire du filtre de boucle 18.

Le comparateur phase-fréquence 16 compare la fréquence (ou la phase) d'un signal délivré par le diviseur de fréquences 14 et la fréquence d'un signal de référence délivré, dans l'exemple de la figure, par un dispositif à quartz 20. Lorsque la fréquence du signal délivré par le diviseur de fréquences est inférieure à celle du signal de référence, le comparateur phase-fréquence fournit, avec le filtre de boucle 18, une tension commandant l'augmentation de la fréquence de l'oscillateur VCO 12. A l'inverse, la fréquence de l'oscillateur VCO est diminuée lorsque la fréquence du signal délivré par le diviseur de fréquences est supérieure à celle du signal de référence.

Le diviseur de fréquences 14 est un dispositif construit autour d'un certain nombre de bascules et ne peut donc diviser la fréquence du signal de l'oscillateur VCO 12 que par des valeurs entières. La rapport de division, ajustable par valeurs entières, est un nombre entier noté N. Une entrée d'ajustage indiquée par une flèche 22 permet de fixer la valeur N.

La fréquence de l'oscillateur VCO, notée $F_{VCO}$ est donc telle que :

$$F_{VCO} = N * F_{ref} \, ,$$

où $F_{ref}$ est la fréquence du signal de référence délivré par le dispositif à quartz 20.

On observe qu'une modification d'une unité de la valeur du rapport de division N (entier), provoque une variation égale à $F_{ref}$, de la fréquence de l'oscillateur VCO. Ainsi, il n'est pas possible d'ajuster la fréquence de l'oscillateur VCO 12 avec une résolution supérieure à $F_{ref}$. Or, dans la mesure où la fréquence du signal de référence est relativement élevée, cette résolution peut s'avérer très insuffisante.

Un ajustage beaucoup plus fin de la fréquence du signal de sortie de la boucle 10, c'est à dire de la fréquence du signal délivré par l'oscillateur VCO 12, peut être obtenu avec un synthétiseur de fréquences conforme à la figure 2 ou du type de celui décrit dans le document brevet US 5,867,068.

Le synthétiseur de fréquences de la figure 2 comprend une boucle à verrouillage de phase 10 avec les mêmes éléments que ceux de la boucle 10 de la figure 1.

Le diviseur de fréquences 14, en revanche, présente non seulement une entrée d'ajustage 22 pour fixer la valeur N du rapport de division, mais également une entrée de commutation 24 pour commuter le rapport de division entre deux ou plusieurs valeurs consécutives autour de la valeur N. Dans l'exemple de la figure 2, l'entrée de commutation 24 du diviseur de fréquences 14 permet de commuter le rapport de division entre deux valeurs qui sont N et N+1.

L'entrée de commutation 24 est reliée à un modulateur sigma-delta 30 et plus précisément à une borne 32 de retenue de dépassement (overflow) de ce modulateur.

Le modulateur sigma-delta 30, qui, dans l'exemple de la figure est un modulateur numérique d'ordre 1 avec un additionneur de mots 31, présente une première entrée numérique 34 pour une consigne d'ajustage notée K. La consigne d'ajustage est additionnée à une valeur numérique délivrée par un registre à décalage 36 du modulateur. Le registre 36 est cadencé par le signal de sortie du diviseur de fréquences 14, et reçoit la sortie de l'additionneur de mots 31. Il est relié à une deuxième entrée numérique 38 de l'additionneur. Lorsque la somme de la consigne d'ajustage et de la sortie du registre 36 est inférieure à la capacité numérique de l'additionneur 31, la retenue de dépassement prend la valeur logique 0, par exemple. En revanche, lorsque la somme est supérieure à la capacité de l'additionneur 31, la retenue prend la valeur logique complémentaire, 1 en l'occurrence.

Le diviseur de fréquences 14 est conçu de façon à effectuer une division de fréquences avec un premier rapport de division lorsque son entrée de commutation 24 reçoit le premier état logique et de façon à effectuer une division avec un deuxième rapport de division, différent de +/-1, lorsque l'entrée 24 reçoit le deuxième état de commutation.

Dans l'exemple décrit, le rapport de division est N pour un état logique 0 et est N+1 pour un état logique 1.

Bien qu'à tout instant le rapport de division du diviseur de fréquences soit un nombre entier, la commutation répétée du rapport entre N et N+1, permet d'obtenir un rapport de division moyen résultant compris entre ces deux valeurs, c'est à dire un rapport non entier.

De façon plus précise, on a :

$$\text{Fvco} = \frac{1}{T_N + T_{N+1}} \left[ T_N * N * F_{ref} + T_{N+1} * (N + 1) * F_{ref} \right]$$

Soit

$$\text{Fvco} = \left[ N + \frac{T_{N+1}}{T_N + T_{N+1}} \right] * F_{ref}$$

Dans ces expressions $T_N$ et $T_{N+1}$ sont respectivement les périodes pendant lesquelles le rapport de division est égal à N et N+1.

En considérant que la consigne d'ajustage K appliquée à la première entrée 34 du modulateur sigma-delta est codée sur L bits, et que la capacité maximum de l'additionneur est de $2^L$-1, on peut définir une composante fractionnaire du rapport de division égale à $\frac{K}{2^L}$. La composante fractionnaire $\frac{K}{2^L}$ est encore notée k dans la suite du texte.

On a:

$$\text{Fvco} = \left[ N + \frac{K}{2^L} \right] * F_{ref}$$

Pour des valeurs faibles de la consigne d'ajustage (K≅0) la fréquence de sortie est voisine de $F_{ref}$*(N) et pour des valeurs fortes de la consigne d'ajustage (K≅$2^L$), la fréquence de sortie est voisine de $F_{ref}$*(N+1).

Il est ainsi possible d'ajuster continûment la fréquence de la boucle à verrouillage de phase entre deux valeurs fixées par le choix du rapport de division N appliquée à l'entrée d'ajustage 22 du diviseur de fréquences 14 et par le choix de la consigne d'ajustage K appliquée au modulateur sigma-delta.

L'analyse spectrale de la sortie d'un synthétiseur de fréquences utilisant une boucle à verrouillage de phase conforme à la figure 2 montre une distribution de composantes de bruit autour d'une raie centrale correspondant à la fréquence $F_{VCO}$. Le bruit résulte de la contribution des différents organes de la boucle à verrouillage de phase ainsi que du modulateur sigma-delta.

Comme le suggère le document (3), déjà mentionné, il est possible de remplacer le modulateur sigma-delta à un étage tel que représenté à la figure 2, par un modulateur sigma-delta à plusieurs étages en cascade et en particulier par un modulateur sigma-delta à deux étages. Un modulateur sigma-delta à deux étages (d'ordre 2) permet en effet une meilleure mise en forme de la répartition fréquentielle du bruit en reportant au moins une partie du bruit vers des fréquences élevées. Ce phénomène, accentué par la multiplication des étages, est désigné par « noise shaping » (mise en forme du bruit).

La demanderesse a cependant mis en évidence une autre source de bruit qui se traduit par des raies secondaires parasites. Celles-ci apparaissent en particulier pour certaines valeurs de la consigne d'ajustage K.

Exposé de l'invention

Comme indiqué précédemment, pour obtenir un rapport de division moyen avec une composante fractionnaire, on commute le rapport de division du diviseur de fréquences à rapports de division entiers, entre deux ou plusieurs valeurs entières généralement consécutives. Pour un rapport de division moyen de N+k, où k représente la composante fractionnaire et N la composante entière, une commutation peut être faite, par exemple, entre N et N+1.

Or, il s'avère que lorsque N+k est voisin de N ou de N+1, c'est à dire lorsque la composante fractionnaire k est proche de 0 ou de 1, l'une des valeurs de rapport de division entière (N ou N+1) devient largement prépondérante par rapport à l'autre dans le jeu des commutations. A titre d'illustration, lorsque k est voisin de 0, c'est à dire lorsque N+k≅N, le rapport de division N est fréquent dans la commutation tandis que le rapport N+ 1 est rare.

La demanderesse a mis en évidence le fait que la répétition élevée d'un même rapport de division entier au détriment d'un ou de plusieurs autres rapports de division entiers raréfiés, conduit également à un bruit qui se manifeste par des raies parasites dans la réponse spectrale du synthétiseur de fréquences.

L'invention a notamment pour but d'éviter le bruit provenant de la répétition excessive de certains rapports de division.

Pour atteindre ce but, l'invention propose un synthétiseur de fréquences, pourvu d'une boucle à verrouillage de phase et comprenant :

- un premier diviseur de fréquences, à rapports de division entiers, connecté entre un oscillateur commandé en tension VCO et un comparateur phase-fréquence PFD,
- un modulateur sigma-delta connecté au premier diviseur de fréquences pour commuter le rapport de division du diviseur de fréquences entre une série d'au moins deux valeurs entières, de façon à obtenir un rapport de division moyen résultant à composante fractionnaire, le modulateur présentant au moins une entrée apte à recevoir une consigne d'ajustage de la composante fractionnaire

Ce synthétiseur se caractérise par le fait qu'il comprend en outre :

- au moins un deuxième diviseur de fréquences à rapport de division fractionnaire fixe, connecté entre l'oscillateur commandé en tension VCO et le diviseur de fréquences à rapports de division entiers, et
- des moyens pour activer le diviseur à rapport de division fractionnaire lorsque la composante fractionnaire (k) du rapport de division moyen est contenue dans au moins une gamme de valeurs déterminée, et pour modifier la consigne d'ajustage de la composante fractionnaire du modulateur sigma-delta de manière à obtenir un rapport de division global desdits premier et deuxième diviseurs de fréquences égal au rapport de division moyen qui serait obtenu sans changement de consigne d'ajustage et en laissant le deuxième diviseur de fréquences inactif.

L'obtention d'un certain rapport de division est en effet dictée par le choix de rapports de division entiers entre lesquels le diviseur à rapports de division entiers peut commuter et le choix d'une consigne d'ajustage de la composante fractionnaire. Celle-ci agit sur le modulateur sigma-delta et dicte les cycles, plus ou moins répétitifs, de la commutation entre les valeurs entières. Ceci est le cas dans les synthétiseurs de l'art antérieur et dans le synthétiseur de l'invention lorsque le diviseur à rapport de division fractionnaire n'est pas activé. On obtient, dans ce cas un certain rapport de division, qui est le rapport moyen déjà mentionné.

En activant le diviseur à rapport de division fractionnaire, le rapport de division global obtenu par le diviseur à rapports entiers et le diviseur à rapport fractionnaire serait ainsi a priori modifié puisqu'un étage supplémentaire de division agit sur le signal.

Toutefois, comme indiqué ci-dessus, une modification appropriée de la consigne d'ajustage, et éventuellement des valeurs entières de division entre lesquelles on effectue une commutation, permet de conserver le rapport de division global égal au rapport de division moyen évoqué ci-dessus.

La modification de la consigne d'ajustage permet alors de modifier les cycles de répétition des rapports entiers de division et ainsi d'éliminer dans le spectre de réponse les raies parasites.

Dans une mise en oeuvre particulière de l'invention, où le rapport de division fractionnaire est 1+ε, la gamme de valeurs déterminées de la composante fractionnaire (k), pour lesquelles le diviseur à rapports de division fractionnaires est activé, peut comporter les valeurs k telles que 0<k<ε/2 et 1-ε/2<k<1 avec e tel que 0<ε<1.

De façon générale, on peut considérer que le diviseur de fréquences à rapport de division fractionnaire est de préférence activé lorsque la composante fractionnaire est voisine de 0 ou de 1 et désactivé dans le cas contraire. Par exemple, les gammes de valeurs de la composantes fractionnaire k, telles que 0<k<0,25 et telles que 0,75<k<1 peuvent correspondre à des gammes d'activation du diviseur de fréquences à rapport de division fractionnaire. Cet exemple correspond à ε=0,5.

L'activation du diviseur de fréquences à rapport de division fractionnaire, permet comme indiqué ci-dessus de modifier la composante fractionnaire du rapport de division moyen qui doit être obtenu par le diviseur de fréquences à rapports de division entiers associé au modulateur sigma-delta.

Pour revenir à l'exemple donné précédemment, lorsque on opère une division supplémentaire par 1,5, ceci revient à ajouter 0,5 à la composante fractionnaire du rapport de division moyen souhaité.

Ainsi en supposant que 0<k<0,25, on a :

$$N+k = N-1+0,5+k'$$

Dans cette expression, la nouvelle composante fractionnaire k' est telle que $0.25 \leq k' \leq 0,75$

De même, on supposant que 0,75<k<1, on a :

$$N+k = N+0,5+k'$$

avec k' telle que $0.25 \leq k' \leq 0,75$.

En d'autres termes, k', la nouvelle composante fractionnaire qui doit être générée par le diviseur de fréquences à rapports de division entiers associé au modulateur sigma-delta, autorise une alternance plus équilibrée entre les rapports de division , par exemple N-1, N et N+1, ou N-1 et N. Ceci permet d'éviter les raies parasites.

Selon un perfectionnement de l'invention, le synthétiseur peut comporter en outre des moyens pour fixer à 1 la valeur de bit de plus faible de poids de la consigne d'ajustage appliquée au modulateur sigma-delta.

La demanderesse a en effet constaté un second phénomène selon lequel la répétition régulière des valeurs logiques selon des motifs courts, par exemple 110011001100 etc., conduit à un petit nombre de raies parasites. L'amplitude de ces raies est alors relativement importante. Ce phénomène a lieu lorsque la valeur de la consigne d'ajustage K est paire.

Lorsqu'en revanche la valeur de la consigne d'ajustage K est impaire, la répétition des motifs reste certes régulière, mais les motifs deviennent très longs. L'énergie du bruit est alors répartie sur un grand nombre de raies parasites de faible amplitude qui s'apparentent à un continuum. L'amplitude des raies prises individuellement est cependant très faible de sorte qu'elles disparaissent dans le bruit des autres organes du synthétiseur de fréquences.

De façon plus précise, la valeur de la fréquence des fréquences parasites peut être donnée par la relation suivante :

$$F_{spur} = \frac{F_{ref} \cdot 2^M}{2^{(O-1)} * 2^L}$$

Dans cette expression $F_{spur}$ indique la fréquence de récurrence des raies parasites et M indique le nombre de fois qu'il est possible de diviser par 2 le nombre K codé sur L bits, et O indique l'ordre du modulateur sigma-delta.

Le fait de fixer à 1 la valeur du bit de plus faible poids de la consigne d'ajustage revient à la rendre impaire. Ceci permet de répartir l'énergie de bruit sur un continuum de fréquences. Pour chacune de ces fréquences, prise individuellement, l'amplitude de bruit est par conséquent très faible. En dehors de la fréquence centrale d'oscillation, aucune raie parasite n'apparaît alors sur le spectre de réponse en fréquence.

En toute rigueur, la modification du bit de plus faible poids provoque une modification de la valeur de consigne K souhaitée par l'utilisateur et donc une modification de la fréquence d'oscillation de la boucle de verrouillage de phase. Toutefois l'erreur de la valeur de consigne effectivement fournie au modulateur sigma-delta reste limitée à $1/2^L$ et conduit à un changement de fréquence imperceptible. A titre d'illustration, pour un codage sur 24 bits (L=24) l'erreur est de

$1/2^{24}$. ($<10^{-7}$).

L'invention concerne également un procédé de synthèse de fréquences au moyen d'un synthétiseur à boucle à verrouillage de phase comportant :

- un premier diviseur de fréquences, à rapports de division entiers connecté entre un oscillateur commandé en tension VCO et un comparateur phase-fréquence PFD,
- un modulateur sigma-delta connecté au premier diviseur de fréquences pour commuter le rapport de division du premier diviseur de fréquences entre une série d'au moins deux valeurs entières, de façon à obtenir un rapport de division moyen résultant à composante fractionnaire, le modulateur présentant une entrée pour une consigne d'ajustage de la composante fractionnaire, et
- au moins un deuxième diviseur de fréquences à rapport de division fractionnaire fixe, connecté entre l'oscillateur commandé en tension VCO et le diviseur de fréquences à rapport de division entiers.

Conformément au procédé, on active ledit deuxième diviseur de fréquences à rapport de division fractionnaire lorsque la composante fractionnaire (k) du rapport de division est contenue dans au moins une gamme de valeurs déterminée et on modifie de manière correspondante la consigne d'ajustage de la composante fractionnaire du modulateur sigma-delta de façon à obtenir un rapport de division global des premier et deuxième diviseurs égal au rapport de division moyen en l'absence de modification de ladite consigne d'ajustage et lorsque le deuxième diviseur de fréquences est inactif.

L'invention concerne également un convertisseur de fréquences comprenant un mélangeur avec une première entrée pouvant être connectée à une source de signal délivrant un signal avec une fréquence à convertir. Le convertisseur comprend par ailleurs une source de signal avec une fréquence de référence, reliée à une deuxième entrée du mélangeur. Conformément à l'invention, la source de signal avec une fréquence de référence comporte un synthétiseur de fréquences tel que décrit ci dessus. Un tel convertisseur de fréquences peut notamment être utilisé dans un téléphone portable.

D'autres caractéristiques et avantages de l'invention ressortiront de la description qui va suivre, en référence aux figures des dessins annexés. Cette description est donnée à titre purement illustratif et non limitatif.

Brève description des figures.

La figure 1, déjà décrite, est un schéma de principe simplifié d'un synthétiseur de fréquences connu, à ajustage de fréquence discret.

La figure 2, déjà décrite, est un schéma de principe simplifié d'un synthétiseur de fréquences connu, à ajustage de fréquence continu.

La figure 3, est un schéma simplifié d'un synthétiseur de fréquences conforme à l'invention.

La figure 4 est un schéma illustrant une réalisation particulière d'un modulateur sigma-delta pour un synthétiseur de fréquences conforme à la figure 3.

La figure 5 est une représentation schématique d'un diviseur de fréquences à rapport de division fractionnaire fixe, utilisé dans le synthétiseur de fréquences de la figure 3.

La figure 6 est un chronogramme illustrant le fonctionnement du diviseur de fréquences à rapport de division fractionnaire fixe de la figure 5.

La figure 7 est une représentation schématique d'un convertisseur de fréquences utilisant un synthétiseur de fréquences conforme à l'invention.

Description détaillée de modes de mise en oeuvre de l'invention.

Les éléments des figures décrites ci-après qui sont identiques, similaires ou équivalents à des éléments correspondants des figures décrites précédemment, sont repérés avec les mêmes références et leur description détaillée n'est pas reprise.

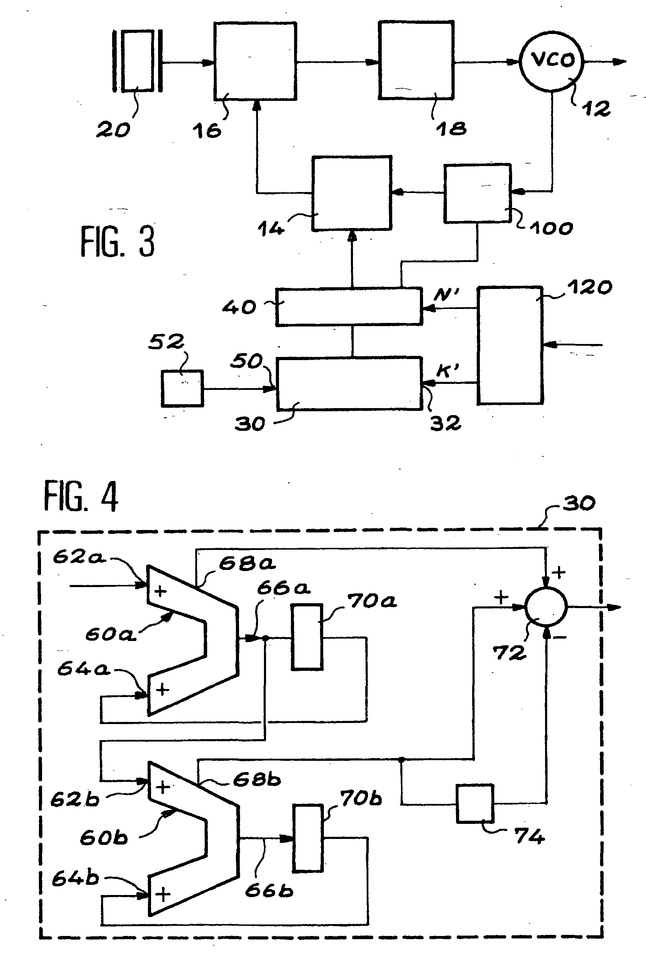

La figure 3 montre un synthétiseur de fréquences construit autour d'une boucle à verrouillage de phase 10, comprenant un oscillateur 12 commandé en tension, un diviseur de fréquences 14, un comparateur phase fréquence 16 et un filtre passe-bas 18.

Le diviseur de fréquences 14 est un diviseur programmable capable de diviser la fréquence d'un signal qui lui est appliqué par un nombre entier. Il est associé à un calculateur 40 de rapport de division destiné à commander un rapport de division noté N en fonction d'un signal délivré par un modulateur sigma-delta 30.

Plus précisément, le calculateur 40, piloté par le modulateur sigma-delta, est capable de commander une commutation du rapport de division entre deux ou plusieurs valeurs consécutives (ou non) entières pour obtenir, de façon résultante, un rapport de division composante fractionnaire. Ce rapport est désigné par rapport "moyen".

Un diviseur de fréquences supplémentaire 100 est connecté entre l'oscillateur commandé en tension 12 (VCO) et le diviseur de fréquences 14 à rapports de division entiers. Le diviseur de fréquences supplémentaire 100, est un diviseur de fréquences présentant un rapport de division fractionnaire mais fixe. Dans l'exemple décrit, le rapport de division fixe est de 1.5. Ceci correspond, en se référant à la description qui précède à une valeur ε=0,5. Ainsi, le diviseur supplémentaire peut soit diviser la fréquence du signal qu'il reçoit par 1,5 (c'est-à-dire 1+ε), lorsqu'il est activé, soit laisser passer le signal inchangé lorsqu'il n'est pas activé. Dans ce cas, la division est en quelque sorte une division par 1. Il convient de préciser que le diviseur 100 peut être remplacé par un diviseur avec un autre rapport fractionnaire ou par une série de deux ou plusieurs diviseurs fractionnaires, connectés à la suite les uns des autres.

La composante fractionnaire k du rapport de division moyen fourni par le diviseur 14 à rapports de division entiers, associé au modulateur sigma-delta, est relié à la consigne d'ajustage K par la relation suivante :

$$k = \frac{K}{2^L} \text{ soit } K = 2^L * k$$

On rappelle que L est le nombre de bits sur lequel est codé la consigne K.

Un étage de circuit ou un calculateur non représentés sont prévus pour établir, en fonction de la fréquence d'oscillation souhaitée, la composante entière N et la composante fractionnaire k du rapport de division moyen. Un tel étage également utilisé dans les dispositifs de l'état de la technique, ne fait pas partie du synthétiseur de fréquences.

Les valeurs N et k (ou K) sont transmises à un calculateur 120 prévu pour vérifier si k n'est pas trop proche des valeurs 0 ou 1, c'est-à-dire si K n'est pas trop proche des valeurs 0 ou $2^L$. Dans l'exemple illustré, on considère que k n'est pas trop proche de 0 ou de 1 lorsque la relation suivante est vérifiée

$$0,25 \leq k \leq 0,75,$$

c'est-à-dire ε/2≤k≤1-ε/2 (avec ε=0,5).

Le calculateur 120 est relié au modulateur sigma-delta 30 et au calculateur de rapports de division 40, déjà évoqué en relation avec la figure 3. Il leur transmet de nouvelles valeurs N' et K' (ou k').

Le tableau I ci-après permet de récapituler de façon générale les règles d'établissement des valeurs N' et K' en fonction de la valeur de k.

Tableau I

| Valeur de k | Valeur de k' | Valeur de N' | Valeur de K' |
|---|---|---|---|
| 0<k<ε/2 | k'=k+ε | N'=N-ε | K'=2L*k' |
| ε/2≤k≤1-ε/2 | k'= k | N'=N | K'=2L*k' |
| 1-ε/2<k<1 | k'=k-ε | N'=N+ε | K'=2L*k' |

On peut observer dans le tableau que N' n'est plus nécessairement une valeur entière, tandis que N était entière. Il convient de préciser à ce sujet que, par un jeu de codage binaire, il est possible de ramener l'expression de N' à une valeur numérique entière.

Le calculateur de rapports de division 40 est relié au diviseur 14 à rapports de division entiers, de façon à imposer une succession de rapports de division entiers dépendant du signal reçu par le convertisseur sigma- delta, de la façon décrite précédemment.

Or, comme le convertisseur sigma-delta reçoit la nouvelle consigne d'ajustage, il permet de commander une séquence de rapports de division entiers du diviseur 14 dans lequel aucune répétition excessive d'un rapport de division (entier) n'a lieu.

Les rapports de division entiers alternent, par exemple, entre des valeurs P et P+1 ou encore, selon une variante, entre des valeurs P-1, P, P+1 et P+2. On peut à ce sujet se reporter au tableau II indiqué dans la suite du texte.

Les rapports de division P-1, P, P+1 et P+2 sont établis dans le calculateur 40 en fonction de la sortie du modulateur sigma-delta et en fonction de la partie entière de N' c'est à dire en fonction de N.

Le calculateur de rapports de division 40 pilote également l'activation ou non du diviseur 100 à rapport de division fractionnaire. Dans un cas particulier où N est une valeur numérique (codée par exemple sur 6 bits), le bit de plus faible poids peut être utilisé pour l'activation (ou non) du diviseur de fréquences à rapport de division fractionnaire tandis que les autres bits (de plus fort poids) peuvent être utilisés pour déterminer la valeur de P mentionnée ci-dessus.

Le tableau II ci-après, qu'il convient de lire en association avec le tableau I, indique selon la valeur de k, la valeur de P en fonction de N, et l'état d'activation du diviseur 100 à rapport de division fractionnaire. Dans le tableau II, P et N sont des valeurs entières.

Tableau II

| Valeur de k | Valeur de N' | Valeur de P | Activation du diviseur 100 (i.e. div. par 1+$\varepsilon$) |
|---|---|---|---|
| 0<k<$\varepsilon$/2 | N-$\varepsilon$ | P=N-1 | Oui (div. par 1.5) |
| $\varepsilon$/2≤k≤1-$\varepsilon$/2 | N | P=N | Non (div. par 1) |
| 1-$\varepsilon$/2<k<1 | N+e | P=N | Oui (div. par 1.5) |

Au sujet de la première ligne du tableau, on peut observer qu'il n'est pas possible de "soustraire" une quantité à N, mais seulement d'y ajouter une quantité. Ainsi N-$\varepsilon$ correspond à (N-1)+(1-$\varepsilon$). La quantité (N-1) est la nouvelle partie entière. Par ailleurs, (1-$\varepsilon$) est positif car $\varepsilon$ est inférieur à 1.

Grâce à l'activation du diviseur 100 à rapport de division fractionnaire, et en utilisant les consignes du tableau I, il est possible, sans changer le rapport de division global obtenu par les deux diviseurs 14 et 100, c'est à dire sans changer la fréquence de sortie du synthétiseur de fréquences, de parfaire l'élimination de raies parasites de bruit dans sa réponse spectrale.

Comme le montre également la figure 3, le convertisseur sigma-delta 30 présente une première entrée 32 reliée au calculateur 120 pour recevoir la consigne notée K' et une deuxième entrée 50, reliée à une bascule 52.

La bascule 52 est une bascule codée sur un bit et verrouillée à la valeur logique 1.

Cette valeur logique 1 est utilisée soit en remplacement du bit de plus faible poids de la consigne K', soit pour former une nouvelle consigne d'ajustage, incluant les valeurs de K' comme bits de plus fort poids, et 1 comme bit de plus faible poids.

Ceci permet, notamment lorsque K' est codé sur un grand nombre de bits de disposer d'une consigne impaire sans changer de façon sensible le rapport de division finalement obtenu.

Ainsi, les raies parasites résultant sur des motifs de répétition courts des rapports de division sont également écartées.

La figure 4 décrite ci-après indique une réalisation possible du modulateur sigma-delta 30 de la figure 3 et permet de mieux comprendre le codage sur deux bits de la sortie 32.

Le modulateur sigma-delta de la figure 4 comprend deux étages en cascade, construits chacun autour d'un additionneur de mots. Un premier additionneur de mots 60a présente une première entrée 62a à laquelle on applique la consigne d'ajustage K' qui, a été rendue impaire.

La sortie 66a du premier additionneur de mots 60a est reliée à sa deuxième entrée 64a par l'intermédiaire d'un registre cadencé 70a. Le registre cadencé 70a peut être piloté par exemple par le signal de fréquence divisée délivré par le diviseur de fréquences. Ainsi, à chaque impulsion, la somme obtenue précédemment à la sortie 66a est renvoyée sur la deuxième entrée.

Lorsque la somme est inférieure à la capacité de l'additionneur de mots, celui-ci délivre en sa borne de dépassement 68a une retenue dont la valeur logique est 0. En revanche, lorsque la somme est supérieure à la capacité une valeur logique (retenue) 1 est délivrée. Dans ce cas, seul le reste de l'addition ne dépassant pas la capacité de l'additionneur de mots est délivré sur la sortie 66a.

Finalement, la borne de dépassement 68a délivre une valeur logique codée sur un seul bit, qui peut occuper les états 0 ou 1.

La sortie 66a est également connectée à la première entrée 62b de l'additionneur de mots 60b du second étage. De même, la sortie 66b de cet additionneur est connectée à sa deuxième entrée 64b par un registre cadencé 70b.

L'additionneur de mots 60b du deuxième étage présente également une borne de dépassement 68b dont la sortie logique codée sur deux bits peut occuper les états 0 et 1.

Un additionneur-soustracteur 72 à trois entrées reçoit en entrée positive les valeurs logiques disponibles sur les bornes de dépassement des deux additionneurs de mots 60a, 60b. Il reçoit également, en entrée négative, la retenue de la borne de dépassement de l'additionneur de mots 60b du deuxième étage, par l'intermédiaire d'une bascule de retard 74.

La sortie 76 de l'additionneur-soustracteur est dirigée vers le calculateur 40 de rapport de division évoqué en relation avec la figure 3.

Le tableau III ci-après donne a titre indicatif la valeur (décimale) de la sortie de l'additionneur-soustracteur 72 en fonction des valeurs des entrées, et indique le rapport de division correspondant imposé au diviseur 14.

Tableau III

| Additionneur 60a (logique) | Additionneur 60b (logique) | Bascule retard 74 (logique) | Sortie 72 | Division par |
|---|---|---|---|---|
| 0 | 0 | 1 | -1 | P-1 |
| 0 | 1 | 0 | 1 | P |
| 1 | 0 | 1 | 0 | P+1 |
| 1 | 1 | 0 | 2 | P+2 |

La division successive par les différents rapports de division ci-dessus, dont la séquence est dictée par la consigne d'ajustage K', permet d'obtenir un rapport de division moyen fractionnaire compris entre P et P+1.

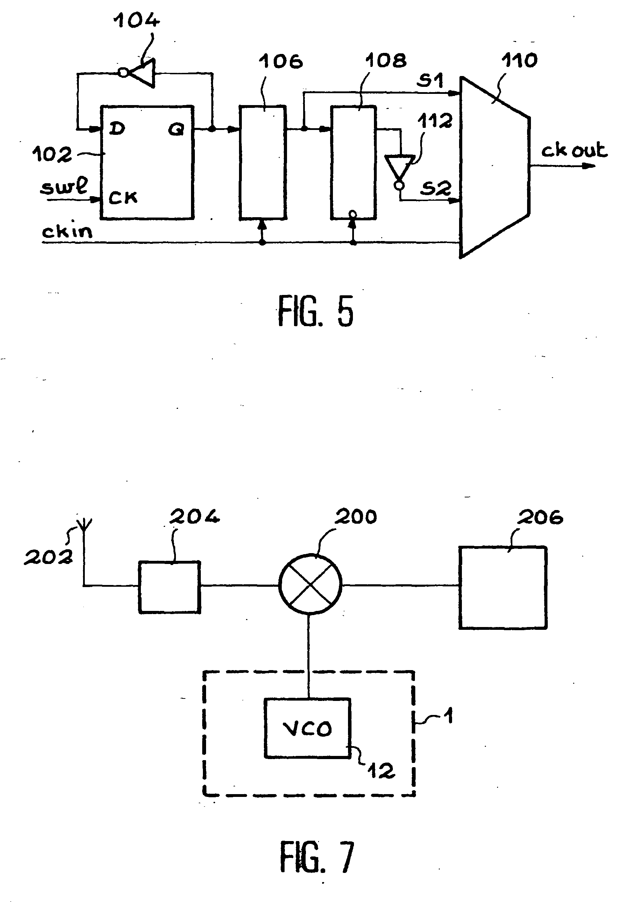

La figure 5, propose une possibilité particulière de réalisation d'un diviseur à rapport fractionnaire. Il s'agit en l'occurrence d'un diviseur par 1,5 tel qu'évoqué précédemment.

Le diviseur de la figure 5 comprend une bascule D 102, de type connu, avec une entrée D et une sortie Q. Une deuxième entrée reçoit un signal de synchronisation noté swl. La sortie Q de la bascule 102 est reliée d'une part à l'entrée D, par l'intermédiaire d'un inverseur 104, et d'autre part à l'entrée d'une première porte latch (à verrouillage) 106.

La sortie de la première porte latch 106 est connectée, d'une part, à l'entrée d'une seconde porte latch 108, et d'autre part, à une première entrée S1 d'un multiplexeur 110. La sortie de la deuxième porte latch 108 est reliée à une deuxième entrée S2 du multiplexeur 110 par l'intermédiaire d'un inverseur 112. Les portes latch 106 et 108, de même que le multiplexeur 110 sont cadencés par un signal d'entrée ckin, qui est en l'occurrence le signal à diviser.

Le signal divisé, noté ckout, disponible à la sortie 114 du multiplexeur 110, correspond au signal d'entrée dans lequel certains fronts de transition entre un état haut et un état bas sont éliminés.

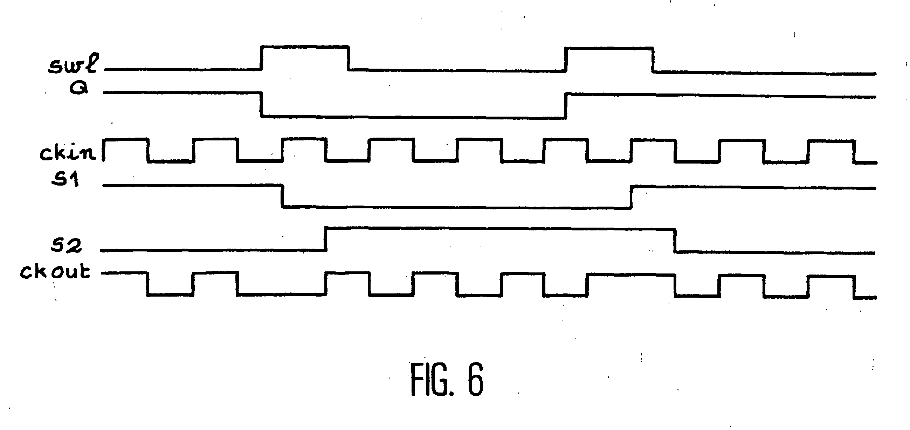

Le fonctionnement du diviseur de la figure 5 est précisé par le chronogramme de la figure 6, qui, sur une même base temporelle, indique l'état des entrées et des sorties des composants du diviseur de la figure 5. Le chronogramme indique en particulier le signal de synchronisation swl, le signal de sortie Q, de la bascule D 102, le signal d'entrée ckin à diviser et le signal disponible sur les entrées S1 et S2 du multiplexeur et le signal divisé de sortie ckout. On observe en comparant les signaux ckin et ckout que des fronts de transition sont éliminés de proche en proche, notamment lorsque les entrées S1 et S2 sont dans un même état logique. L'élimination de ces fronts correspond à la division de la fréquence.

La figure 7 montre une application d'un synthétiseur de fréquences conforme à l'invention à la réalisation d'un convertisseur de fréquences et plus précisément à un convertisseur de fréquences dans un émetteur-récepteur de signaux.

Le convertisseur comprend un mélangeur auquel est connecté d'une part une source de signal à convertir, par exemple une antenne 202 associée à un filtre 204, et d'autre part une unité de traitement 206. L'unité de traitement 206 reçoit le signal dont la fréquence est convertie. Il s'agit, par exemple, d'une unité de traitement d'un téléphone portable.

Le mélangeur 200 reçoit également un signal de fréquence de référence d'une deuxième source de signal qui, dans l'exemple décrit, provient d'un oscillateur VCO 12 d'un synthétiseur de fréquences 1 conforme à l'invention.

<u>Documents cités</u>

(1) EP-B-0 661 816
(2) EP-A-0 563 400
(3) "Fractional-N PII using delta-sigma modulation" de Thomas Stichelbout Aalborg University, August 5, 1997, pages 1 à 21.

**Revendications**

1. Synthétiseur de fréquences, pourvu i) d'une boucle à verrouillage de phase (10), ii) d'un premier diviseur de fréquences (14), à rapports de division entiers, connecté entre un oscillateur (12) commandé en tension et un comparateur phase-fréquence (16), et iii) d'un modulateur sigma-delta (30) connecté audit premier diviseur de fréquences (14) pour commuter le rapport de division dudit premier diviseur de fréquences (14) entre une série d'au moins deux valeurs entières, de façon à obtenir un rapport de division moyen résultant à composante fractionnaire, ledit modulateur (30) présentant au moins une entrée (32) apte à recevoir une consigne d'ajustage de la composante fractionnaire, **caractérisé en ce qu'**il comprend en outre au moins un second diviseur de fréquences (100), à rapport de division fractionnaire fixe, connecté entre l'oscillateur commandé en tension (12) et ledit premier diviseur de fréquences à rapports de division entiers (14), et des moyens d'activation pour activer ledit second diviseur à rapport de division fractionnaire (100) lorsque la composante fractionnaire (k) du rapport de division moyen est contenue dans au moins une gamme de valeurs déterminée, et pour modifier la consigne d'ajustage de la composante fractionnaire dudit modulateur (30) de manière à obtenir un rapport de division global desdits premier (14) et second (100) diviseurs de fréquence égal au rapport de division moyen en l'absence de modification de ladite consigne d'ajustage et lorsque ledit second diviseur de fréquences est inactif.

2.  Synthétiseur selon la revendication 1, dans lequel le rapport de division fractionnaire fixe est $1+\varepsilon$ et dans lequel la gamme de valeurs déterminées de la composante fractionnaire (k) comprend les valeurs k telles que : $0<k<\varepsilon/2$ et $1-\varepsilon/2<k<1$ où $\varepsilon$ est une valeur comprise strictement entre 0 et 1.

3.  Synthétiseur selon la revendication 2, dans lequel $\varepsilon=0,5$.

4.  Synthétiseur selon la revendication 1, dans lequel les moyens pour activer le diviseur fractionnaire et pour modifier la consigne d'ajustage de la composante fractionnaire du modulateur sigma-delta comportent un calculateur de rapport de division (40) connecté au diviseur de fréquences à rapport de division fractionnaire (100) pour mettre en service, respectivement hors service ledit diviseur.

5.  Synthétiseur de fréquences selon la revendication 1, dans lequel le modulateur sigma-delta (30) est un modulateur à deux étages.

6.  Synthétiseur selon la revendication 1, comprenant en outre des moyens (52) pour fixer à 1 la valeur de bit de plus faible de poids de la consigne d'ajustage appliquée au modulateur sigma-delta.

7.  Procédé de synthèse de fréquences au moyen d'un synthétiseur de fréquences pourvu i) d'une boucle à verrouillage de phase (10), ii) un premier diviseur de fréquences (14), à rapports de division entiers, connecté entre un oscillateur (12) commandé en tension et un comparateur phase-fréquence (16), iii) un modulateur sigma-delta (30) connecté audit premier diviseur de fréquences (14) pour commuter le rapport de division dudit premier diviseur de fréquences (14) entre une série d'au moins deux valeurs entières, de façon à obtenir un rapport de division moyen résultant à composante fractionnaire, ledit modulateur (30) présentant au moins une entrée (32) apte à recevoir une consigne d'ajustage de la composante fractionnaire, **caractérisé en ce qu'**il consiste à pourvoir ledit synthétiseur, entre ledit oscillateur commandé en tension (12) et ledit premier diviseur de fréquences à rapports de division entiers (14), d'au moins un second diviseur de fréquences (100), à rapport de division fractionnaire fixe, et à activer ledit second diviseur à rapport de division fractionnaire (100) lorsque la composante fractionnaire (k) du rapport de division moyen est contenue dans au moins une gamme de valeurs déterminée et à modifier la consigne d'ajustage de la composante fractionnaire dudit modulateur (30) de manière à obtenir un rapport de division global desdits premier (14) et second (100) diviseurs de fréquences égal au rapport de division moyen en l'absence de modification de ladite consigne d'ajustage et lorsque ledit second diviseur de fréquences est inactif.

8.  Procédé selon la revendication 7, dans lequel on active ledit diviseur de fréquences à rapport de division fractionnaire fixe lorsque la composante fractionnaire k du rapport de division est telle que $0<k<\varepsilon/2$ ou que $1-\varepsilon/2<k<1$, et on désactive ledit diviseur de fréquences à rapport de division fractionnaire fixe lorsque la composante fractionnaire k du rapport de division est telle que $\varepsilon/2 \le k \le 1-\varepsilon/2$.

9.  Procédé selon la revendication 8, dans lequel on applique une nouvelle consigne d'ajustage k' au modulateur sigma-delta (30) avec $k'=k+\varepsilon$ lorsque $0<k<\varepsilon/2$ et $k'=k-\varepsilon$ lorsque $1-\varepsilon/2 < k < 1$.

10. Convertisseur de fréquences comprenant un mélangeur (200) avec une première entrée connectée à une première source de signal (202, 204) délivrant un signal avec une fréquence à convertir, et comprenant une deuxième source de signal (1) avec une fréquence de référence, la deuxième source étant reliée à une deuxième entrée du mélangeur, **caractérisé en ce que** la deuxième source de signal (1) avec une fréquence de référence comprend un synthétiseur de fréquences (12) conforme à la revendication 1.

11. Utilisation d'un convertisseur de fréquences selon la revendication 10 dans un téléphone portable.

**Claims**

1. A frequency synthesizer comprising i) a phase-locked loop (10), ii) a first frequency divider (14) having integral dividing ratios, connected between a voltage-controlled oscillator (12) and a phase/frequency comparator (16), and iii) a sigma-delta modulator (30) connected to the first frequency divider (14) for switching the dividing ratio of the first frequency divider (14) between a series of at least two integral values, so as to obtain a resulting mean dividing ratio having a fractional component, the modulator (30) having at least an input (32) suitable for receiving an adjusting instruction of the fractional component, **characterized in that** it further comprises at least a second frequency divider (100) having a fixed fractional dividing ratio, connected between the voltage-controlled oscillator (12) and the first frequency divider having integral dividing ratios (14), and means for activating the second divider having a fractional dividing ratio (100) when the fractional component (k) of the mean dividing ratio is contained in at least a given range of values, and for modifying the adjusting instruction of the fractional component of said modulator (30) so as to obtain a rough dividing ratio of the first (14) and second (100) frequency dividers equal to the mean dividing ratio when there is no change of said adjusting instruction and when said second frequency divider is inactive.

2. A synthesizer as claimed in claim 1, in which the fixed fractional dividing ratio is $1+\varepsilon$ and in which the given value range of the fractional component (k) comprises the values k so that: $0<k<\varepsilon/2$ and $1-\varepsilon/2<k<1$ where $\varepsilon$ is a value strictly comprised between 0 and 1.

3. A synthesizer as claimed in claim 2, in which $\varepsilon=0.5$.

4. A synthesizer as claimed in claim 1, in which the means for activating the fractional divider and for modifying the adjusting instruction of the fractional component of the sigma-delta modulator comprise a dividing ratio calculator (40) connected to the frequency divider having a fractional dividing ratio (100) for activating or deactivating, respectively, said divider.

5. A frequency synthesizer as claimed in claim 1, in which the sigma-delta modulator (30) is a two-stage modulator.

6. A synthesizer as claimed in claim 1, further including means (52) for setting the value of the least significant bit of the adjusting instruction applied to the sigma-delta modulator to 1.

7. A method of synthesizing frequencies by means of a phase-locked synthesizer, comprising i) a phase-locked loop (10), ii) a first frequency divider (14) having integral dividing ratios, connected between a voltage-controlled oscillator (12) and a phase/frequency comparator (16), iii) a sigma-delta modulator (30) connected to the first frequency divider (14) for switching the dividing ratio of the first frequency divider (14) between a series of at least two integral values, so as to obtain a resulting mean dividing ratio having a fractional component, the modulator (30) having at least an input (32) suitable for receiving an adjusting instruction of the fractional component, **characterized in that** it consists of providing said synthesizer between said voltage controlled oscillator (12) and said first frequency divider having integral dividing ratios (14), at least a second frequency divider having a fractional dividing ratio (100), of activating said second frequency divider having a fractional dividing ratio (100) when the fractional component (k) of the mean dividing ratio is contained in at least a given range of values, and of modifying the adjusting instruction of the fractional component of said modulator (30) so as to obtain a rough dividing ratio of the first (14) and second (100) frequency dividers equal to the mean dividing ratio when there is no change of said adjusting instruction and when said second frequency divider is inactive.

8. A method as claimed in claim 7, in which said frequency divider having a fixed fractional dividing ratio is activated when the fractional component k of the dividing ratio is such that $0<k<\varepsilon/2$ or that $1-\varepsilon/2<k<1$, and said fixed frequency divider having a fractional dividing ratio is deactivated when the fractional component k of the dividing ratio is such that $\varepsilon/2\leq k\leq 1-\varepsilon/2$.

9. A method as claimed in claim 8, in which a new adjusting instruction k' is applied to the sigma-delta modulator (30) with $k'=k+\varepsilon$ when $0<k<\varepsilon/2$ and $k'=k-\varepsilon$ when $1-\varepsilon/2<k<1$.

10. A frequency converter comprising a mixer (200) which has a first input connected to a first signal source (202, 204) delivering a signal with a frequency to be converted, and comprising a second signal source (1) with a reference frequency, the second source being connected to a second input of the mixer, **characterized in that** the second signal source (1) with a reference frequency comprises a frequency synthesizer (12) as claimed in claim 1.

**11.** The use of a frequency converter as claimed in claim 10 in a portable telephone.

**Patentansprüche**

**1.** Frequenzsynthesizer, versehen i) mit einer Phasenverriegelungsschleife (10), ii) einem ersten Frequenzteiler (14) mit ganzzahligen Teilungsverhältnissen, angeschlossen zwischen einem Oszillator (12) mit gesteuerter Spannung und einem Phase-Frequenz-Vergleicher (16), und iii) einem Sigma-Delta-Modulator (30), angeschlossen an den besagten ersten Frequenzteiler (14) zum Umschalten des Teilungsverhältnisses des besagten ersten Frequenzteilers (14) zwischen einer Serie mit mindestens zwei ganzzahligen Werten, um ein durchschnittliches Teilungsverhältnis als Ergebnis mit Bruchkomponente zu erhalten, wobei der besagte Modulator (30) mindestens einen Eingang (32) hat und dazu in der Lage ist, eine Anpassungsvorgabe der Bruchkomponente zu erhalten, **dadurch gekennzeichnet, dass** er außerdem mindestens einen zweiten Frequenzteiler (100) mit festem Bruchteilungsverhältnis enthält, angeschlossen zwischen dem in der Spannung gesteuerten Oszillator (12) und dem besagten ersten Frequenzteiler mit ganzzahligen Teilungsverhältnissen (14), und Aktivierungsmittel für die Aktivierung des besagten zweiten Teilers mit Bruchteilungsverhältnis (100), wenn die Bruchkomponente (k) des durchschnittlichen Teilungsverhältnisses in mindestens einem bestimmten Wertebereich enthalten ist, für die Änderung der Anpassungsvorgabe der Bruchkomponente des besagten Modulators (30), um ein globales Teilungsverhältnis des besagten ersten (14) und zweiten (100) Frequenzteilers gleich einem durchschnittlichen Teilungsverhältnis ohne Änderung der besagten Anpassungsvorgabe zu erhalten, wenn der besagten zweite Frequenzteiler inaktiv ist.

**2.** Synthesizer nach Anspruch 1, in dem das feste Bruchteilungsverhältnis 1+$\varepsilon$ ist und in dem der festgelegte Wertebereich der Bruchkomponente (k) Werte k enthält wie: 0<k<$\varepsilon$/2 und 1-$\varepsilon$/2<k<1, wobei $\varepsilon$ ein strikt zwischen 0 und 1 enthaltener Wert ist.

**3.** Synthesizer nach Anspruch 2, in dem $\varepsilon$=0,5.

**4.** Synthesizer nach Anspruch 1, in dem die Mittel für die Aktivierung des Bruchteilers und für die Änderung der Anpassungsvorgabe der Bruchkomponente des Sigma-Delta-Modulators einen Rechner für das Teilungsverhältnis (40) enthalten, angeschlossen an den Frequenzteiler mit Bruchteilungsverhältnis (100), um den besagten Teiler einzuschalten respektive auszuschalten.

**5.** Frequenzsynthesizer nach Anspruch 1, in dem der Sigma-Delta-Modulator (30) ein Modulator mit zwei Stufen ist.

**6.** Synthesizer nach Anspruch 1 mit außerdem Mitteln (52) für die Festlegung auf 1 des Werts des Bits mit dem geringsten Stellenwert der an dem Sigma-Delta-Modulator angewendeten Anpassungsvorgabe.

**7.** Frequenzsyntheseverfahren, versehen mit einem Frequenzsynthesizer mit i) einer Phasenverriegelungsschleife (10), ii) einem ersten Frequenzteiler (14) mit ganzzahligen Teilungsverhältnissen, angeschlossen zwischen einem Oszillator (12) mit gesteuerter Spannung und einem Phase-Frequenz-Vergleicher (16), iii) einem Sigma-Delta-Modulator (30), angeschlossen an den besagten ersten Frequenzteiler (14) zum Umschalten des Teilungsverhältnisses des besagten ersten Frequenzteilers (14) zwischen einer Serie mit mindestens zwei ganzzahligen Werten, um ein durchschnittliches Teilungsverhältnis als Ergebnis einer Bruchkomponente zu erhalten, wobei der besagte Modulator (30) mindestens einen Eingang (32) enthält, dazu in der Lage, eine Anpassungsvorgabe der Bruchkomponente zu erhalten, **dadurch gekennzeichnet, dass** der besagte Synthesizer zwischen dem besagten in der Spannung gesteuerten Oszillator (12) und dem besagten ersten Frequenzteiler mit ganzzahligen Teilungsverhältnissen (14) mit mindestens einem zweiten Frequenzteiler (100) mit festem Bruchteilungsverhältnis versehen ist, um den besagten zweiten Teiler mit Bruchteilungsverhältnis (100) zu aktivieren, wenn die Bruchkomponente (k) des durchschnittlichen Teilungsverhältnisses in mindestens einem bestimmten Wertebereich enthalten ist, um die Anpassungsvorgabe der Bruchkomponente des besagten Modulators (30) zu ändern, um ein globales Teilungsverhältnis des besagten ersten (14) und zweiten (100) Frequenzteilers gleich dem durchschnittlichen Teilungsverhältnis ohne Änderung der besagten Anpassungsvorgabe zu erhalten, wenn der besagte zweite Frequenzteiler inaktiv ist.

**8.** Verfahren nach Anspruch 7, in dem man den besagten Frequenzteiler mit festem Bruchteilungsverhältnis aktiviert, wenn die Bruchkomponente k des Teilungsverhältnisses wie 0<k<$\varepsilon$/2 oder 1-$\varepsilon$/2<k<1 ist, und man den besagten Frequenzteiler mit festem Bruchteilungsverhältnis deaktiviert, wenn die Bruchkomponente k des Teilungsverhältnisses wie $\varepsilon$/2 $\leq$ k $\leq$ 1-$\varepsilon$/2 ist.

9.  Verfahren nach Anspruch 8, in dem man eine neue Anpassungsvorgabe k' an dem Sigma-Delta-Modulator (30) anwendet, mit k'=k+$\epsilon$, wenn 0<k<$\epsilon$/2 und k'= k-$\epsilon$, wenn 1-$\epsilon$/2 < k < 1.

10. Frequenzumsetzer mit einem Mischer (200) mit einem ersten Eingang, angeschlossen an eine erste Signalquelle (202, 204), die ein Signal mit einer zu wandelnden Frequenz ausgibt, und mit einer zweiten Signalquelle (1) mit einer Referenzfrequenz, wobei die zweite Quelle mit einem zweiten Eingang des Mischers verbunden ist, **dadurch gekennzeichnet, dass** die zweite Signalquelle (1) mit einer Referenzfrequenz einen Frequenzsynthesizer (12) entsprechend Anspruch 1 enthält.

11. Verwendung eines Frequenzumsetzers nach Anspruch 10 in einem Mobilofon.

FIG. 1

FIG. 2

FIG. 3

FIG. 4

FIG. 5

FIG. 7

FIG. 6

EP 1 193 878 B1